# EUROPÄISCHE PATENTSCHRIFT

(11) **EP 1 970 720 B1**
(45) Veröffentlichungstag und Bekanntmachung des Hinweises auf die Patenterteilung: **21.09.2011**
(21) Anmeldenummer: 08004059.5
(22) Anmeldetag: 05.03.2008
(51) Int. Cl.: G01R 31/28, G01R 35/00, G01R 33/00

(54) **Halbleiterbauelement und Verfahren zum Testen eines solchen**
Semiconductor component and method for testing the same
Elément semi-conducteur et procédé destiné à tester celui-ci

(30) Priorität: 12.03.2007 DE 102007012214
(43) Veröffentlichungstag der Anmeldung: 17.09.2008
(73) Patentinhaber: Micronas GmbH, 79108 Freiburg i. Br. (DE)
(72) Erfinder: Bidenbach, Reiner, 79279 Vörstetten (DE); Heberle, Klaus, 79312 Emmendingen (DE)
(74) Vertreter: Koch Müller Patentanwaltsgesellschaft mbH

(56) Entgegenhaltungen:
- DE-A1- 19 539 458
- DE-A1- 19 606 826

## Beschreibung

Die Erfindung betrifft ein Halbleiterbauelement, dos auf einem Halbleiterchip mindestens ein Sensorelement zum Messen einer physikalischen Größe und eine Auswerteeinrichtung aufweist. Außerdem betrifft die Erfindung ein Verfahren zum Testen eines solchen Halbleiterbauelements.

Ein derartiges Halbleiterbauelement, das als Sensorelement einen Magnetfeldsensor aufweist, ist aus DE 10 2005 028 461 Al bekannt. Damit das Halbleiterbauelement bei der Fertigung überprüft werden kann, ohne dass an dem Halbleiterbauelement ein genau definiertes Magnetfeld erzeugt werden muss, hat das Halbleiterbauelement Abgriffe zum Anlegen eines Messstroms an das Sensorelement und Abgriffe zum Messen einer Spannung, die aufgrund des Messstroms in dem Sensorelement erzeugt werden. Dadurch ist es möglich, den elektrischen Widerstand des Sensorelements zu bestimmen und damit das Sensorelement auf einfache Weise zu testen. Da mit Hilfe des von dem Teststrom an dem Sensorelement erzeugten Testsignals auch die dem Sensorelement nachgeschaltete Auswerteeinrichtung stimuliert wird, kann der komplette Signalpfad, also der Magnetfeldsensor mit Auswerteschaltung vollständig elektrisch überprüft werden. Ein Nachteil des Halbleiterbauelements besteht jedoch noch darin, dass zum Testen des Halbleiterbauelements keine Standardtestgeräte verwendet werden können. Diese weisen nämlich ferromagnetische Teile auf, über die unkontrolliert ein Magnetfeld in den Magnetfeldsensor eingeleitet werden konnte, das an dem Magnetfeldsensor ein Messsignal bewirken könnte. Dieses Messsignal überlagert sich der durch den Messstrom erzeugten Spannung und verfascht dadurch dass Messergebnis. In der DE 10 2005 028 461 Al wird zwar vorgeschlagen, zum Messen der magnetischen Empfindlichkeit des Halbleiterbauelements den Magnetfeldsensor gegen eventuelle äußere Magnetfelder abzuschirmen, jedoch kann eine solche Abschirmung in der Praxis nicht vollständig erreicht werden. Auch erfordert die magnetische Abschirmung einen nicht unerheblichen apparativen Aufwand.

Des Weiteren sind aus der DE 195 39 458 A1 und der DE 196 06 826 A1 und der DE Schaltungen zum Testen von Halbleiterbauelementen bekannt. Hierbei werden die Sensoren mit zusätzlichen Testsignalen beaufschlagt

Es besteht deshalb die Aufgabe, ein Halbleiterbauelement der eingangs genannten Art zu schaffen, das unter Verwendung eines Standard-Testgeräts auf einfache Weise getestet werden kann. Ferner besteht die Aufgabe, ein Verfahren der eingangs genannten Art zu schaffen, das auf einfache Weise eine Funktionsüberprüfung des Halbleiterbauelements ermöglicht.

Diese Aufgabe wird bezüglich des Halbleiterbauelements mit den Merkmalen des Patentanspruchs 1 gelöst. Erfindungsgemäß ist dabei das Halbleiterbauelement zwischen einer ersten und einer zweiten Betriebsart umschaltbar, wobei in der ersten Betriebsart das Sensorelement für die zu messende physikalische Größe empfindlich und ein Messsignalausgang des Sensorelements mit einem Eingangsanschluss der Auswerteeinrichtung verbunden ist, wobei in der zweiten Betriebsart das Sensorelement für die zu messende physikalische Größe unempfindlich und/oder der Signalpfad zwischen dem Messsignalausgang und dem Eingangsanschluss unterbrochen ist, wobei auf dem Halbleiterchip eine Testsignalquelle zur Erzeugung eines das Messsignal des Sensorelements simulierenden Testsignals angeordnet ist, und wobei die Testsignalquelle in der zweiten Betriebsart mit dem Eingangsanschluss der Auswerteeinrichtung verbunden oder verbindbar ist. In vorteilhafter Weise kann dann das Halbleiterbauelement in der zweiten Betriebsart getestet werden, ohne dass in der Umgebung des Halbleiterbauelements ein bestimmter Wert der physikalischen Größe, für deren Messung das Sensorelement vorgesehen ist, eingehalten oder eingestellt werden muss. Auch können aufwändige und komplizierte Maßnahmen zur Abschirmung des Sensorelements gegen die zu messende physikalische Größe eingespart werden, da das Sensorelement in der zweiten Betriebsart gegen die physikalische Größe unempfindlich ist. In der zweiten Betriebsart kann der elektrische Signalpfad zwischen dem Sensorelement und der Auswerteeinrichtung beispielsweise mittels mindestens eines Schaltelements unterbrochen sein. Bei einem Sensorelement, das für die Messung eine Betriebsspannung oder einen Betriebsstrom benötigt, ist es aber auch möglich, dass die Betriebsspannung oder der Betriebsstrom des Sensorelements in der zweiten Betriebsart abgeschaltet ist. Gegebenenfalls können auch beide Maßnahmen miteinander kombiniert sein. Dennoch kann die Auswerteeinrichtung getestet werden, indem mittels der Testsignalquelle anstelle des Sensor-Messsignals ein Testsignal in die Auswerteeinrichtung eingespeist und ein aufgrund des Testsignals von der Auswerteeinrichtung erzeugtes Ausgangssignal gemessen und gegebenenfalls mit einem vorgegebenen Referenzsignal verglichen wird. Somit kann die Auswerteeinrichtung mit Hilfe von in einer Halbleiterfabrik standardmäßig vorhandenen Testgeräten kostengünstig und schnell überprüft werden. Unter einer Auswerteeinrichtung wird die komplette elektrische Schaltung des Halbleiterbauelements mit Ausnahme des Sensorelements verstanden. Der Funktionstest des Sensorelements kann gegebenenfalls in einem früheren Fertigungsstadium des Halbleiterbauelements erfolgen, insbesondere wenn der Halbleiterchip des Sensorelements im Verbund mit anderen Halbleiterchips auf einem Wafer angeordnet ist. Ein entsprechendes Testverfahren für das Sensorelement ist in DE 10 2005 028 461 A1 beschrieben.

Vorteilhaft ist, wenn die Testsignalquelle einen Datenspeicher aufweist, in dem mindestens eine dem Sensorelement zugeordnete Kenngröße abgelegt ist, und wenn die Testsignalquelle derart ausgestaltet ist, dass sie das Testsignal in Abhängigkeit von der mindestens einen Kenngröße erzeugt. In dem Datenspeicher kann als Kenngröße insbesondere die Empfindlichkeit, die das Sensorelement in der ersten Betriebsart gegenüber der zu messenden physikalischen Größe aufweist, abgelegt sein. Dadurch ist es möglich, mit Hilfe des Testsignals das Sensorsignal sehr genau nachzubilden und somit die Auswerteeinrichtung noch präziser zu testen.

Bei einer bevorzugten Ausgestaltung der Erfindung weist die Testsignalquelle eine Stelleinrichtung für das Testsignal auf, wobei ein Steuereingang der Stelleinrichtung zum Einstellen des Testsignals direkt oder indirekt über eine Ansteuereinrichtung mit einem externen Anschluss des Halbleiterbauelements verbunden ist. Somit können in der zweiten Betriebsart mit Hilfe eines an dem externen Anschluss angeschlossenen Testgeräts genau definierte Testsignalwerte an der Testsignalquelle abgerufen werden. Dabei ist es sogar möglich, die Testsignalwerte in Abhängigkeit von Vorgaben des Testgeräts und/oder in Abhängigkeit von der Antwort der Auswerteeinrichtung auf das Testsignal zu verändern.

Bei einer zweckmäßigen Ausführungsbrm der Erfindung ist die Stelleinrichtung mit einer seriellen Schnittstelle verbunden, an die über den externen Anschluss Befehlescodes zum Einstellen des Testsignals übermittelbar sind. Die Datenverbindung zwischen dem an dem externen Anschluss angeschlossenen Textgerät und der Testsignalquelle ist dann weitgehend unempfindlich gegenüber EMV-Einstrahlung.

Vorteilhaft ist, wenn die serielle Schnittstelle zum Umschalten der Betriebsart des Halbleiterbauelements mit einer Betriebsartenumschalteinrichtung verbunden ist. Dadurch kann an dem Halbleiterbauelement ein zusätzlicher externer Anschluss zum Umschalten der Betriebsart eingespart werden.

Bei einer bevorzugten Ausgestaltung der Erfindung ist das Sensorelement ein Magnetfeldsensor, insbesondere ein Hall-Sensorelement. Es ist aber auch denkbar, dass das Sensorelement ein Drucksensor oder ein optischer Sensor ist.

Die vorstehend genannte Aufgabe wird bezüglich des Verfahrens mit den Merkmalen des Patentanspruchs 8 gelöst. Vorteilhaft ist demgemäß ein Verfahren zum Testen eines Halbleiterbauelements, das auf einem Halbleiterchip mindestens ein Sensorelement zum Messen einer physikalischen Größe und eine über einen Signalpfad mit dem Sensorelement verbundene Auswerteeinrichtung aufweist, wobei der Signalpfad zwischen dem Sensorelement und der Auswerteeinrichtung während eines Funktionstests der Auswerteeinrichtung gesperrt oder unterbrochen wird, wobei ein das Messsignal des Sensorelements simulierendes Testsignal bereitgestellt und anstelle des Messsignals in die Auswerteeinrichtung eingespeist wird, und wobei mindestens ein von dem Testsignal abhängiges Ausgangssignal der Auswerteeinrichtung gemessen wird.

Das gemessene Ausgangssignal kann dann gegebenenfalls mit einem Referenzsignal verglichen werden, wobei das Halbleiterbauelement in Abhängigkeit vom Ergebnis dieses Vergleichs als funktionsfähig eingestuft und für Messungen der physikalischen Größe freigegeben oder als nicht funktionsfähig ausgesondert wird. Da der Signalpfad zwischen dem Sensorelement und der Auswerteeinrichtung während eines Funktionstests gesperrt oder unterbrochen ist, kann die von dem Sensorelement abgetrennte restliche Schaltung des Halbleiterbauelements bei der Fertigung auf einfache Weise mittels eines Standardtestgeräts überprüft werden.

Zum Testen des Sensorelements kann in dem Sensorelement ein Stromfluss erzeugt und der elektrische Widerstand des Sensorelements gemessen werden.

Somit kann das Sensorelement auf Funktion überprüft werden, ohne dass an dem Sensorelement ein bestimmter Wert der physikalischen Größe, für deren Messung das Sensorelement vorgesehen ist, erzeugt werden muss.

Erwähnt werden soll noch, dass die Betriebsartenumschalteinrichtung mit einem vorzugsweise auf dem Halleiterchip und/oder an einem diesen umgrenzenden Bauelementgehäuse angeordneten elektrischen Anschlusskontakt verbunden sein kann, wobei die Betriebsart durch Anlegen eines externen elektrischen Potentials an den Anschlusskontakt und/oder durch Einspeisen eines elektrischen Stroms in den Anschlusskontakt umschaltbar ist. Dabei ist es sogar möglich, dass über den elektrischen Kontakt eine für den Betrieb des Halbleiterbauelements benötigte Versorgungsspannung an den Halbleiterchip anlegbar ist, und dass die Umschaltung der Betriebsart in Abhängigkeit von der Höhe der an den Anschlusskontakt angelegten Versorgungsspannung erfolgt.

Nachfolgend sind Ausführungsbeispiele der Erfindung anhand der Zeichnung näher erläutert. Es zeigen zum Teil stärker schematisiert:
- Fig. 1: ein Blockschaltbild eines ersten Ausführungsbeispiels eines Halbleiterbauelements und
- Fig. 2: ein Blockschaltbild eines zweiten Ausführungsbeispiels des Halbleiterbauelements.

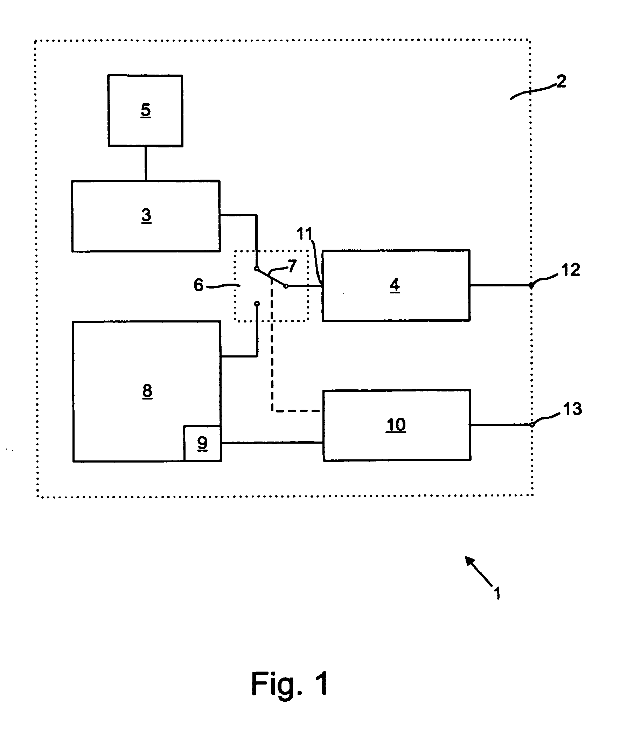

Ein in Fig. 1 im Ganzen mit 1 bezeichnetes Halbleiterbauelement weist einen in einem Bauelementgehäuse angeordneten Halbleiterchip 2 auf, in den ein magnetfeldempfindliches Sensorelement 3, nämlich eine Hallplatte, und eine Auswerteeinrichtung 4 dafür integriert sind. In den Halbleiterchip 2 ist auch eine Stromquelle 5 integriert, die zum Einspeisen eines Hallplattenstroms in das Sensorelement 3 mit diesem verbunden ist.

Das Halbleiterbauelement 1 weist eine Betriebsumschalteinrichtung 6 auf, mittels der es in eine erste und eine zweiten Betriebsart bringbar. In der ersten Betriebsart liegt an einem Messsignalausgang des Sensorelements 3 ein von der das Sensorelement 3 durchsetzenden magnetischen Flussdichte abhängiges Messsignal an.

Wie in Fig. 1 erkennbar ist, hat die Betriebsumschalteinrichtung 6 ein Schaltelement 7, welches in der ersten Betriebsart den Messsignalausgang mit einem Eingangsanschluss 11 der Auswerteeinrichtung 4 verbindet. Der Eingangsanschluss 11 ist an einem in der Zeichnung nicht näher dargestellten Anschlusskontakt 12 angeschlossen, der außen an dem Bauelementgehäuse zugänglich ist.

In der zweiten Betriebsart ist das Schaltelement 7 derart geschaltet, dass der Signalpfad zwischen dem Messsignalausgang des Sensorelements 3 und dem Eingangsanschluss 11 der Auswerteeinrichtung 4 unterbrochen ist. Der Eingangsanschluss 11 ist über das Schaltelement 7 mit einem Testsignalausgang einer Testsignalquelle 8 verbunden. Die Testsignalquelle 8 ist in den Halbleiterchip 2 integriert. Es sind aber auch andere Ausführungsfbomen denkbar, bei denen das Testsignal mittels einer externen Testsignalquelle erzeugt und über an dem Halbleiterbauelement vorgesehene Anschlusskontakte an den Eingangsanschluss 11 der Auswerteeinrichtung 4 angelegt wird.

Die Testsignalquelle 8 hat einen nicht flüchtigen Datenspeicher 9, in dem eine Kenngröße für die Empfindlichkeit des Sensorelements 3 abgelegt ist. Die Kenngrö-ße wird bei der Fertigung des Halbleiterwafers, aus dem der Halbleiterchip des Sensorelements 3 hergestellt wird, durch Messung ermittelt. Der Halbleiterwafer weist dazu Abgriffe zum Anschließen einer Messstromquelle auf Mit Hilfe der Messstromquelle wird ein elektrischer Strom erzeugt und über die Abgriffe in das Sensorelement 3 eingespeist. Der durch den Stromfluss in dem Sensorelement 3 hervorgerufene Spannungsabfall wird gemessen und aus dem Strom und dem Spannungsabfall wird der elektrische Widerstand des Sensorelements bestimmt. Dieser wird in dem Datenspeicher 9, der beispielsweise ein PROM sein kann, abgelegt.

Die Testsignalquelle 8 hat eine in der Zeichnung nicht näher dargestellte Stelleinrichtung, mittels der die Amplitude des Testsignals einstellbar ist. Die Stelleinrichtung ist über eine serielle Schnittstelle 10 mit einem externen Anschluss 13 des Halbleiterbauelements 1 verbunden. Über die serielle Schnittstelle 10 können mittels eines an dem externen Anschluss 13 angeschlossenen Testgeräts Sollwerte für eine zu simulierende magnetische Flussdichte an die Stelleinrichtung übermittelt werden. In Abhängigkeit von dem jeweiligen Sollwert und der im Datenspeicher 8 abgelegten Kenngröße wird die Amplitude des Testsignals derart eingestellt, dass das Testsignal dem Messsignal des Sensorelements 3 entspricht, das am Eingangsanschluss 11 der Auswerteeinrichtung anliegen würde, wenn das Halbleiterbauelement 1 in der ersten Betriebsart betrieben würde und sich das Sensorelement 3 in einem Magnetfeld befände, dessen magnetische Flussdichte dem Sollwert entspricht. Mittels der Testsignalquelle 8 kann also das Messsignal des Sensorelements 3 genau nachgebildet werden.

Über die Schnittstelle 10 kann auch die Betriebsart des Halbleiterbauelements 1 umgeschaltet werden. Die Schnittstelle 10 ist dazu mit einer Betriebsartenumschalteinrichtung 6 verbunden.

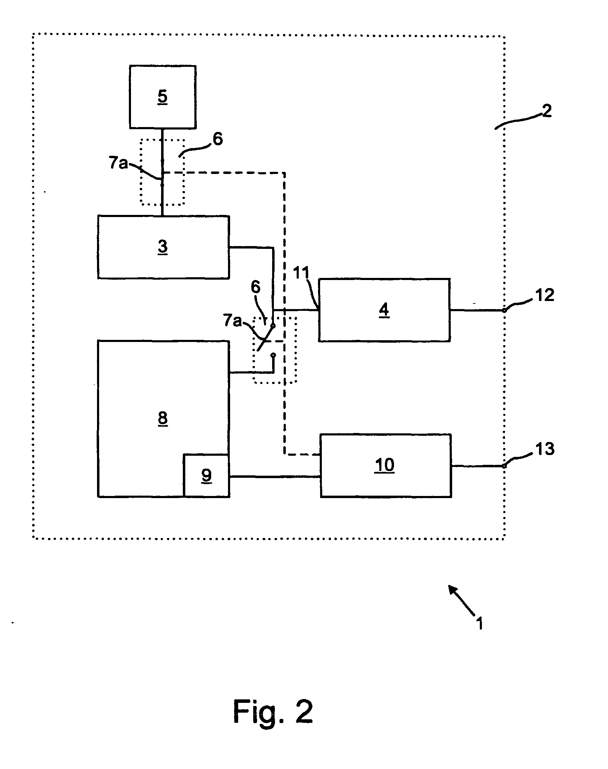

Bei dem in Fig. 2 gezeigten Ausführungsbeispiel ist das Sensorelement 3 in der zweiten Betriebsart für Magnetfelder unempfindlich. Die Betriebsumschalteinrichtung 6 weist dazu ein erstes Schaltelement 7a auf, über das die Stromquelle 5 mit einem Hallplattenstromanschluss des Sensorelements 3 verbunden ist. In der ersten Betriebsart ist das erste Schaltelement 7a derart geschaltet, dass das Sensorelement 3 von einem Hallplattenstrom durchflossen wird. In der zweiten Betriebsart ist der Stromfluss zu den Hallplattenstromanschlüssen unterbrochen.

Die Betriebsumschalteinrichtung 6 hat ferner ein zweites Schaltelement 7b, das im Signalpfad zwischen dem Testsignalausgang der Testsignalquelle und dem Eingangsanschluss 11 der Auswerteeinrichtung 4 angeordnet ist. In der ersten Betriebsart ist der Signalpfad zwischen dem Testsignalausgang und dem Eingangsanschluss 11 der Auswerteeinrichtung 4 unterbrochen und in der zweiten Betriebsart ist der Testsignalausgang mit dem Eingangsanschluss 11 der Auswerteeinrichtung 4 verbunden. Wie bei dem Ausführungsbeispiel nach Fig. 1 kann über die Schnittstelle 10 die Betriebsart des Halbleiterbauelements 1 umgeschaltet werden.

## Patentansprüche

1. Halbleiterbauelement (1), das auf einem Halbleiterchip (2) mindestens ein Sensorelement (3) zum Messen einer physikalischen Größe und eine Auswerteeinrichtung (4) aufweist, wobei das Halbleiterbauelement (1) zwischen einer ersten und einer zweiten Betriebsart umschaltbar ist, die jeweils so Konfiguriert ist, dass in der ersten Betriebsart das Sensorelement (3) mittels einer Stromquelle (5) verbunden und für die zu messende physikalische Größe empfindlich und ein Messsignalausgang des Sensorelements (3) mit einem Eingangsanschluss (11) der Auswerteeinrichtung (4) verbunden ist,
**dadurch gekennzeichnet, dass**
eine Kenngröße, die das Sensorelement gegenüber der zu messenden Größe aufweist, in einem Datenspeicher (9) abgelegt ist, und in der zweiten Betriebsart das Sensorelement (3) für die zu messende physikalische Größe unempfindlich ist, wobei die Verbindung zwischen der Stromquelle (5) und / oder der Signalpfad zwischen dem Messsignalausgang des Sensorelements (3) und dem Eingangsanschluss (11) unterbrochen ist, und auf dem Halbleiterchip (2) eine Testsignalquelle (8) zur Erzeugung eines in Abhängigkeit der gespeicherten Kenngröße das Messsignal des Sensorelements (3) simulierenden Testsignals angeordnet ist, und das Testsignal und die Testsignalquelle (8) in der zweiten Betriebsart mit dem Eingangsanschluss (11) der Auswerteeinrichtung (4) verbunden ist, um mit Hilfe des Testsignals das Sensorsignal nachzubilden.

2. Halbleiterbauelement (1) nach Anspruch 1, **dadurch gekennzeichnet, dass** die Testsignalquelle (8) eine Stelleinrichtung für das Testsignal aufweist, und dass ein Steuereingang der Stelleinrichtung zum Einstellen des Testsignals direkt oder indirekt über eine Ansteuereinrichtung mit einem externen Anschluss des Halbleiterbauelements (1) verbunden ist.

3. Halbleiterbauelement (1) nach Anspruch 1 oder Anspruch 2, **dadurch gekennzeichnet, dass** die Stelleinrichtung mit einer seriellen Schnittstelle (10) verbunden ist, an die über den externen Anschluss Befehlescodes zum Einstellen des Testsignals Ubermittelbar sind.

4. Halbleiterbauelement (1) nach einem der Ansprüche 1 bis 3, **dadurch gekennzeichnet, dass** die serielle Schnittstelle (10) zum Umschalten der Betriebsart des Halbleiterbauelements (1) mit einer Betriebsartenumschalteinrichtung (6) verbunden ist.

5. Halbleiterbauelement (1) nach einem der Ansprüche 1 bis 4, **dadurch gekennzeichnet, dass** das Sensorelement (3) ein Magnetfeldsensor ist, insbesondere ein Hall-Sensorelement.

6. Verfahren zum Testen eines Halbleiterbauelements (1), das auf einem Halbleiterchip (2) mindestens ein Sensorelement (3) zum Messen einer physikalischen Größe und eine über einen Signalpfad mit dem Sensorelement (3) verbundene Auswerteeinrichtung (4) aufweist,
**dadurch gekennzeichnet, dass**
in einer ersten Betriebsart, eine Kenngröße, die das Sensorelement gegenüber der zumessenden Größe aufweist, in einem Speicher abgelegt wird, und in einer zweiten Betriebsart der Signalpfad zwischen dem Sensorelement (3) und der Auswerteeinrichtung (4) während eines Funktionstests der Auswerteeinrichtung (4) gesperrt oder unterbrochen wird, wobei ein das Messsignal des Sensorelements (3) simulierenden Test-Signal in Abhängigkeit der gespeicherten Kenngröße erzeugt und anstelle des Messsignals in die Auswerteeinrichtung (4) eingespeist wird, und wobei mindestens ein von dem Testsignal abhängiges Ausgangssignal der Auswerteeinrichtung (4) gemessen wird.

7. Verfahren nach Anspruch 6, **dadurch gekennzeichnet, dass** zum Testen des Sensorelements (3) ein Stromfluss in dem Sensorelement (3) erzeugt und der elektrische Widerstand des Sensorelements (3) gemessen wird.

## Claims

1. Semiconductor component (1) comprising on a semiconductor chip (2) at least one sensor element (3) for measuring a physical magnitude and an evaluating device (4), wherein the semiconductor component (1) is switchable between a first operating mode and a second operating mode which are each so configured that in the first operating mode the sensor element (3) is connected by means of a current source (5) and is sensitive to the physical magnitude to be measured and a measurement signal output of the sensor element (3) is connected with an input connection (11) of the evaluating device (4), **characterised in that** a characteristic magnitude which the sensor element has by comparison with the magnitude to be measured is filed in a data memory (9) and in the second operating mode the sensor element (3) is insensitive to the physical magnitude to be measured, wherein the connection between the current source (5) and/or the signal path between the measurement signal output of the sensor element (3) and the input connection (11) is interrupted, and a test signal source (8) for producing a test signal simulating the measurement signal of the sensor element (3) in dependence on the stored characteristic magnitude is arranged on the semiconductor chip (2), and the test signal and the test signal source (8) in the second operating mode are connected with the input connection (11) of the evaluating device (4) in order to simulate the sensor signal with the help of the test signal.

2. Semiconductor component (1) according to claim 1, **characterised in that** the test signal source (8) comprises a setting device for the test signal and that a control input of the setting device is, for setting the test signal, connected directly or indirectly by way of an activating device with an external connection of the semiconductor element (1).

3. Semiconductor component (1) according to claim 1 or claim 2, **characterised in that** the setting device is connected with a serial interface (10) to which command codes for setting the test signal are transmissible by way of the external connection.

4. Semiconductor component (1) according to any one of claims 1 to 3, **characterised in that** the serial interface (10) is, for switching over the operating mode of the semiconductor component (1), connected with an operating mode switch-over device (6).

5. Semiconductor component (1) according to any one of claims 1 to 4, **characterised in that** the sensor element (3) is a magnetic field sensor, particularly a Hall sensor element.

6. Method of testing a semiconductor component (1), which comprises on a semiconductor chip (2) at least one sensor element (3) for measuring a physical magnitude and an evaluating device (4) connected with the sensor element (3) by way of signal path, **characterised in that** in a first operating mode a characteristic magnitude which the sensor element has relative to the magnitude to be measured is filed in a memory and in a second operating mode the signal path between the sensor (3) and the evaluating device (4) is blocked or interrupted during a function test of the evaluating device (4), wherein a test signal simulating the measurement signal of the sensor element (3) is generated in dependence on the stored characteristic magnitude and is supplied to the evaluating device (4) instead of the measurement signal and wherein at least one output signal, which is dependent on the test signal, of the evaluating device (4) is measured.

7. Method according to claim 6, **characterised in that** for testing the sensor element (3) a current flow in the sensor element (3) is produced and the electrical resistance of the sensor element (3) is measured.

## Revendications

1. Composant semi-conducteur (1) présentant sur une microplaquette semi-conductrice (2), au moins un élément capteur (3) pour mesurer une grandeur physique et un dispositif d'analyse (4), dans lequel le composant semi-conducteur (1) est commutable entre un premier et un deuxième mode de fonctionnement qui est à chaque fois configuré de manière que dans le premier mode de fonctionnement, l'élément capteur (3) est relié au moyen d'une source de courant (5) et sensible à la grandeur physique à mesurer et de manière à ce qu'une sortie de signal de mesure de l'élément capteur (3) étant reliée à une connexion d'entrée (11) du dispositif d'analyse (4)
**caractérisé en ce qu'**une caractéristique que l'élément capteur présente par rapport à la grandeur à mesurer est sauvegardée dans une mémoire de données (9) et **en ce que** dans le deuxième mode de fonctionnement, l'élément capteur (3) est insensible à la grandeur physique à mesurer, la liaison entre la source de courant (5) et/ou le chemin du signal entre la sortie du signal de mesure de l'élément capteur (3) et la connexion d'entrée (11) étant interrompue et **caractérisé par** une source de signal test (8) prévue sur la microplaquette semi-conductrice (2) pour la génération d'un signal test simulé dépendant de la caractéristique mise en mémoire du signal de mesure de l'élément capteur (3) et en ce que le signal test et la source de signal (8) sont reliés à la connexion d'entrée (11) du dispositif d'analyse (4) dans le deuxième mode de fonctionnement pour récréer le signal du capteur à l'aide du signal test.

2. Composant semi-conducteur (1) selon la revendication 1 **caractérisé en ce que** la source de signal test (8) présente une station de réglage pour le signal test, et **en ce que** l'entrée de commande de la station de réglage est reliée directement ou indirectement à travers un dispositif d'excitation comportant une connexion externe du composant semi-conducteur pour le réglage du signal de test.

3. Composant semi-conducteur (1) selon la revendication 1 ou la revendication 2 **caractérisé en ce que** la station de réglage est reliée à une sous-station série (10) à qui par une connexion externe peut être transmis des codes de commande pour le réglage du signal de test.

4. Composant semi-conducteur (1) selon l'une des revendications 1 à 3 **caractérisé en ce que** la sous-station série (10) est reliée à un dispositif de commutation (6) pour commuter le mode de fonctionnement du composant semi-conducteur (1).

5. Composant semi-conducteur (1) selon l'une des revendications 1 à 4 **caractérisé en ce que** l'élément capteur (3) est un capteur de champ magnétique, en particulier un capteur à effet Hall.

6. Procédé pour tester un composant semi-conducteur (1) qui présente sur une microplaquette semi-conductrice (2) au moins un élément capteur (3) pour la mesure d'une grandeur physique et un dispositif d'analyse (4) relié à l'élément de capteur (3) par un chemin de signal
**caractérisé en ce que**
dans un premier mode de fonctionnement, une caractéristique que l'élément capteur présente par rapport à la grandeur à mesurer, est sauvegardée dans une mémoire, et **en ce que** dans un deuxième mode de fonctionnement, le chemin du signal est bloqué ou interrompu entre l'élément capteur (3) et le dispositif d'analyse (4) pendant une fonction de test du dispositif d'analyse (4), **en ce que** l'on génère un signal de test simulant le signal de mesure de l'élément capteur (3) dépendant de la caractéristique mise en mémoire, **en ce que** le signal test alimente le dispositif d'analyse (4) à la place du signal de mesure et **en ce que** l'on mesure au moins un signal de sortie du dispositif d'analyse (4) dépendant du signal test.

7. Procédé selon la revendication 6 **caractérisé en ce que** pour tester l'élément capteur (3), on génère un courant dans l'élément capteur (3) et on mesure la résistance électrique de l'élément capteur (3).
